(19) Europäisches Patentamt / European Patent Office / Office européen des brevets

(11) **EP 1 858 192 A2**

(12) **DEMANDE DE BREVET EUROPEEN**

(43) Date de publication:
**21.11.2007 Bulletin 2007/47**

(51) Int Cl.:
***H04L 7/02*** *(2006.01)*

(21) Numéro de dépôt: **07105144.5**

(22) Date de dépôt: **28.03.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **16.05.2006 FR 0604348**

(71) Demandeur: **ARTERIS**
**78280 Guyancourt (FR)**

(72) Inventeurs:
• **Douady, César**
**91400 Orsay (FR)**
• **Montperrus, Luc**
**78180 Montigny Le Bretonneux (FR)**

(74) Mandataire: **Delprat, Olivier**
**Bureau Casalonga & Josse**
**Bayerstrasse 71/73**
**80335 München (DE)**

(54) **Procédé de réalisation d'un circuit de synchronisation de données échangées de manière asynchrone entre deux blocs synchrones, et circuit de synchronisation élaboré à partir d'un tel procédé.**

(57) Le procédé concerne la réalisation d'un circuit de synchronisation de données échangées de manière asynchrone entre deux blocs synchrones. Le circuit comprend au moins une bascule critique apte à générer un signal de décision de réception d'une nouvelle donnée. En outre, le procédé comprend :
- une étape (20) de mesure du gain de la boucle combinatoire de la bascule critique générant le signal de décision de réception d'une nouvelle donnée ;
- une étape d'estimation (21) d'un temps de résolution de métastabilité à partir dudit gain et d'un temps moyen statistique prédéterminé entre défaillances ; et
- une étape d'ajout (22) dudit temps de résolution au paramètre temporel de synthèse de la ou lesdites bascules critiques, ledit paramètre temporel comprenant le temps de propagation du front actif du signal de cadencement d'horloge du bloc de réception, de l'entrée dudit signal à la sortie d'une bascule critique.

# FIG.2

```
┌─────────────────────┐
│ Mesure gain de      │─ 20
│ boucle combinatoire │
└─────────────────────┘
          │
          ▼
┌─────────────────────┐
│ Estimation temps    │─ 21
│ de résolution       │
└─────────────────────┘
          │
          ▼
┌─────────────────────┐
│ Ajout du temps      │─ 22
│ de résolution       │
└─────────────────────┘
          │
          ▼
┌─────────────────────┐
│ Test du circuit     │─ 23
│ obtenu              │
└─────────────────────┘
```

EP 1 858 192 A2

# Description

La présente invention porte sur un procédé de réalisation d'un circuit de synchronisation de données échangées de manière asynchrone entre deux blocs synchrones, et sur un circuit de synchronisation élaboré à partir d'un tel procédé.

Les fréquences utilisées dans les systèmes électroniques actuels étant de plus en plus élevées, les problèmes de métastabilité tendent à devenir cruciaux.

De manière classique, pour réduire les problèmes de métastabilité lors d'un transfert asynchrone de données entre deux blocs synchrones, plusieurs bascules sont mises en série à l'entrée du bloc synchrone de réception des données. Une autre possibilité consiste à augmenter le gain des boucles combinatoires de ces bascules mises en série.

De manière classique, un maximum de transferts ne sont effectués que lorsque les données sont stables. Pour savoir si une nouvelle donnée à transférer d'un domaine d'horloge à un autre est présente et stable, un unique signal, appelé signal de décision, est utilisé.

Le transfert de ce signal de décision d'un domaine d'horloge à l'autre peut provoquer des situations de métastabilité.

De plus, ce type de solution atteint à présent ses limites avec les nouveaux systèmes sur silicium comprenant un nombre croissant d'échantillonnages critiques et des fréquences d'échantillonnages élevées.

De surcroît, aucune mesure de l'utilisation du cycle d'horloge du bloc de réception n'est effectuée, et ce temps peut être gaspillé en délais de transport, si, par exemple, le placement des différentes bascules n'est pas maîtrisé. Cette solution empirique n'a donc plus une fiabilité suffisante pour les systèmes électroniques actuels.

En outre, le temps d'établissement et le temps de maintien de la deuxième bascule mise en série sont perdus, et des cycles entiers du signal de cadencement d'horloge du bloc de réception sont exclusivement dédiés au traitement de la métastabilité, ce qui ajoute des problèmes de latence.

Aussi, un but de l'invention est de pallier à ces problèmes, en particulier de limiter la présence de métastabilité dans un circuit, et de diminuer le temps de cycle d'horloge de réception.

Ainsi, selon un aspect de l'invention, il est proposé un procédé de réalisation d'un circuit de synchronisation de données échangées de manière asynchrone entre deux blocs synchrones, ledit circuit comprenant au moins une bascule critique apte à générer un signal de décision de réception d'une nouvelle donnée. Le procédé comprend une étape de mesure du gain de la boucle combinatoire de la bascule générant le signal de décision de réception d'une nouvelle donnée, et une étape d'estimation d'un temps de résolution de métastabilité à partir dudit gain et d'un temps moyen statistique prédéterminé entre défaillances. En outre, le procédé comprend une étape d'ajout dudit temps de résolution au paramètre temporel de synthèse de la ou lesdites bascules critiques, ledit paramètre temporel comprenant le temps de propagation du front actif du signal de cadencement d'horloge du bloc de réception, de l'entrée dudit signal à la sortie d'une bascule critique.

Un tel procédé de réalisation permet d'obtenir un circuit de synchronisation de données fiable à des fréquences de fonctionnement élevées du système.

On entend par métastabilité de la boucle combinatoire d'une bascule, la capacité, pour un état de non-équilibre d'un point de cette boucle combinatoire, à persister durant un long intervalle de temps, un état de non-équilibre d'un point de la boucle combinatoire correspondant à un potentiel de ce point ne correspondant ni à un 1 logique ni à un 0 logique.

Le transfert du signal de décision, utilisé pour savoir si une nouvelle donnée à transférer d'un domaine d'horloge à un autre est stable, pouvant provoquer des situations de métastabilité, est qualifié d'événement critique. En outre, la ou les premières bascules qui échantillonnent ledit événement critique dans le domaine d'horloge d'arrivée et qui génèrent ledit signal de décision sont nommées bascules critiques.

En outre, un temps moyen statistique prédéterminé entre défaillances du système est garanti.

Selon un mode de mise en oeuvre, ladite étape de mesure dudit gain est effectuée en utilisant un simulateur électrique et en calculant la position d'équilibre métastable de la ou lesdites bascules critiques, par dichotomie.

Ainsi, la mesure du gain et la position d'équilibre métastable sont déterminées de manière très précise.

Selon un mode de mise en oeuvre, ladite étape d'estimation du temps de résolution de métastabilité comprend une analyse de la répartition statistique des événements critiques engendrés par ladite nouvelle donnée reçue, sur un cycle du signal de cadencement d'horloge du bloc de réception, pendant ledit temps moyen statistique prédéterminé entre défaillances. En outre, ladite étape d'estimation du temps de résolution de métastabilité comprend une détermination d'un délai statistique minimum entre lesdits événements critiques et l'instant critique d'échantillonnage du signal de cadencement d'horloge ($Clk_2$) du bloc de réception, ledit instant critique d'échantillonnage étant l'instant d'arrivée d'une donnée mettant la boucle combinatoire de la bascule critique dans un état de métastabilité permanent. De plus, ladite étape d'estimation comprend une conversion dudit délai statistique minimum en une différence de potentiels avec le potentiel d'équilibre métastable de la ou lesdites bascules, et une utilisation de ladite différence de potentiels et dudit gain, pour estimer ledit temps de résolution de métastabilité.

Ainsi, on peut estimer avec une précision améliorée ledit temps de résolution de métastabilité.

Selon un mode de mise en oeuvre, le procédé comprend, en outre, une étape de test de fabrication dudit circuit de synchronisation de données par un modèle à fautes de transitions en diminuant ledit temps de transition dudit temps de résolution.

Ainsi, il est possible de tester le circuit résultant de la mise en oeuvre du procédé.

Selon un autre aspect de l'invention, il est également proposé un circuit de synchronisation de données échangées de manière asynchrone entre deux blocs synchrones, élaboré à partir du procédé décrit ci-dessus. Le circuit comprend un ensemble de N bascules aptes à générer un signal de décision de réception d'une nouvelle donnée, montées en parallèle, et un multiplexeur recevant en entrée les signaux de sortie des N bascules dudit ensemble. En outre, le circuit comprend des moyens de gestion des N bascules dudit ensemble et dudit multiplexeur, aptes à commander un échantillonnage des données reçues, de manière cyclique, par lesdites N bascules, et aptes à commander ledit multiplexeur, de sorte qu'il transmette les données d'une desdites N bascules avec un décalage de N-1 cycles du signal de cadencement d'horloge du bloc de réception.

Un tel circuit permet de garantir temps moyen statistique prédéterminé entre défaillances du système (MTBF) dues à la métastabilité.

Selon un mode de réalisation, le nombre N desdites bascules montées en parallèle correspond au nombre de cycles du signal de cadencement d'horloge du bloc de réception nécessaire et suffisant pour être supérieur ou égal au temps de résolution de métastabilité desdites bascules.

Selon un mode de réalisation, le nombre N desdites bascules montées en parallèle est réduit à N=1.

D'autres buts, caractéristiques et avantages de l'invention apparaîtront à la lecture de la description suivante, de quelques exemples nullement limitatifs, et faisant référence aux dessins annexés, sur lesquels :

- la figure 1 illustre une solution comprenant trois bascules mises en série ;
- la figure 2 illustre un procédé selon un aspect de l'invention ; et
- la figure 3 illustre un circuit élaboré à partir du procédé, selon un aspect de l'invention.

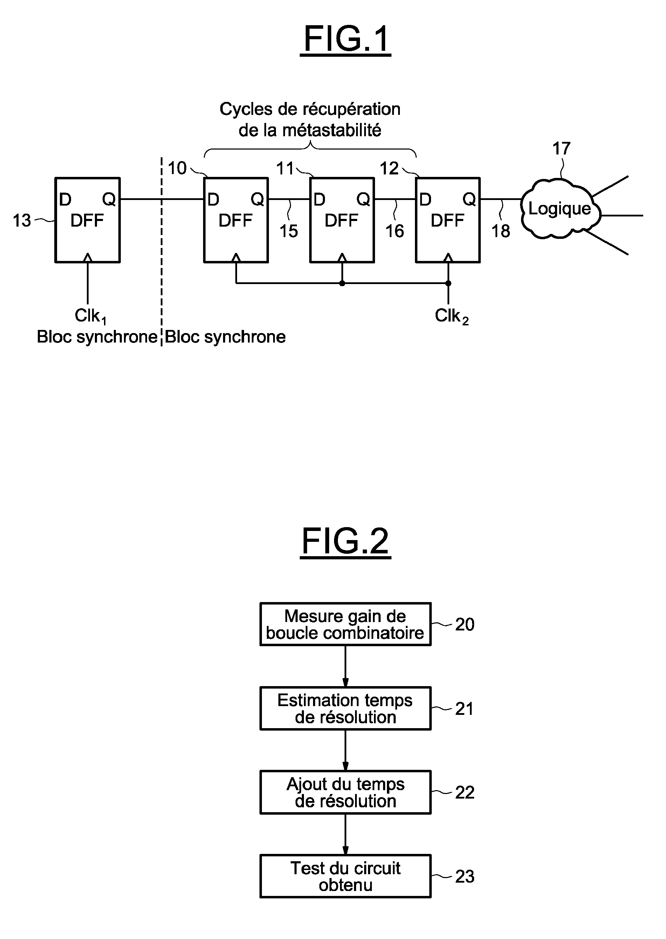

Tel qu'illustré sur la figure 1, une solution au problème de métastabilité comprend deux bascules critiques 10, 11 à gain de boucle combinatoire augmenté, disposées en série dans le bloc synchrone de réception. Une troisième bascule 12, disposée en série en aval des bascules critiques 10 et 11, sert à échantillonner le signal de décision stabilisé de sortie de la bascule critique 11.

Les deux bascules 10, 11 partagent le même signal de cadencement d'horloge $Clk_2$ du bloc synchrone de réception.

Les données transmises proviennent d'un autre bloc synchrone, comprenant une bascule 13 de signal de cadencement d'horloge $Clk_1$ du bloc synchrone d'émission.

La sortie de la bascule 13 est reliée à l'entrée de la bascule 10 par une connexion 14, la sortie de la bascule 10 est reliée à l'entrée de la bascule 11 par une connexion 15, et la sortie de la bascule 11 est reliée à l'entrée de la bascule 12 par une connexion 16.

La sortie de la bascule 12 est reliée à des éléments de logique 17 par une connexion 18.

Dans ce type de circuit, plusieurs bascules critiques en série peuvent être nécessaires pour générer ledit signal de décision, quand une seule ne suffit pas.

Un tel circuit ne permet plus de garantir un temps moyen prédéterminé entre défaillances aux vues des fréquences élevées de fonctionnement des systèmes électroniques actuels.

En outre, dans un tel système, aucune mesure de l'utilisation du cycle du signal de cadencement d'horloge $Clk_2$ de réception n'est effectuée, et ce temps peut être gaspillé en délais de transport si le placement des différentes bascules n'est pas maîtrisé.

Le temps d'établissement et le temps de propagation du front actif du signal de cadencement d'horloge du bloc de réception, de l'entrée dudit signal à la sortie de la deuxième bascule critique 11 ("clock-to-output delay" en langue anglaise) sont perdus, et deux cycles entiers du signal de cadencement d'horloge $Clk_2$ de réception sont dédiés exclusivement au traitement de la métastabilité, ce qui n'exclue pas des problèmes de latence.

Le nombre de bascules est empirique, généralement seul un cycle du signal de cadencement d'horloge $Clk_2$ de réception est dédié à la métastabilité.

Tel qu'illustré sur la figure 2, le procédé de réalisation d'un circuit de synchronisation de données selon un aspect de l'invention comprend une étape 20 de mesure du gain de la boucle combinatoire de la bascule générant le signal de décision de réception d'une nouvelle donnée.

On choisit une bascule dont le gain est élevé, ou, si la bibliothèque standard utilisée comprend une bascule dédiée à la métastabilité, on utilise cette bascule à fort gain.

A l'aide d'un simulateur électrique, on détermine, par des approches successives en procédant par dichotomie le potentiel d'équilibre métastable en un point de la boucle combinatoire, dans les conditions de température et d'alimentation requises, avec le maximum de précision possible.

Une bascule, dite maître-esclave, comprend deux boucles combinatoires associées respectivement à la partie maître et à la partie esclave. La boucle combinatoire qui nous intéresse dans la présente invention est la boucle combinatoire associée à la partie maître, puisqu'elle échantillonne les données provenant du domaine d'horloge du bloc d'émission.

Au-dessus du potentiel d'équilibre, la bascule évolue de manière à atteindre l'un des deux états stables de la bascule, et au-dessous de ce potentiel d'équilibre, la bascule évolue en sens contraire, de manière à atteindre l'autre état stable de la bascule.

Plus on se rapproche de la position d'équilibre métastable, et plus le retour à une position d'équilibre de la bascule dure longtemps.

On appelle instant d'échantillonnage critique non pas l'instant de la transition active du signal de cadencement d'horloge, mais l'instant d'arrivée d'une donnée qui mettrait théoriquement la bascule dans sa position métastable de façon permanente.

Lorsqu'on atteint la limite de précision supportée par les algorithmes du simulateur et les modèles des composants de la bascule, on peut mesurer le gain de la boucle combinatoire, et s'assurer qu'il est constant dans la zone de linéarité, c'est-à-dire la zone dans laquelle la courbe de potentiel suit une courbe exponentielle.

Ensuite, on estime un temps de résolution de métastabilité à partir du gain déterminé de la boucle combinatoire, et d'un temps moyen prédéterminé entre défaillances, lors d'une étape 21.

On fixe un temps moyen statistique prédéterminé entre défaillances qui soit acceptable (MTBF ou "Mean Time Between Failures" en langue anglaise). Le temps moyen statistique entre défaillances du système est la moyenne statistique des temps entre deux défaillances successives du système, et définit une période de référence pour laquelle on détermine le nombre d'événements critiques en fonction de la fréquence d'émission des données. On étudie ensuite la distribution de ces évènements au cours du temps sur la période du signal de cadencement d'horloge de réception.

D'une manière générale, l'hypothèse d'une distribution uniforme des événements est acceptable. Toutefois, dans certains cas, les signaux de cadencement d'horloge, bien qu'étant asynchrones entre eux, peuvent présenter des phénomènes de battement dus par exemple à un couplage des générateurs de signaux de cadencement d'horloge par les alimentations.

Une fois le modèle de distribution statistique établi, on en déduit, pour un temps moyen entre défaillances fixé, l'écart statistique de temps minimal entre un événement et l'instant d'échantillonnage critique.

Pour une distribution donnée, plus le nombre d'événements est important, et plus un événement peut statistiquement se rapprocher de la position critique.

En d'autres termes, la probabilité qu'un événement arrive, espacé de l'instant d'échantillonnage critique, d'une durée inférieure à cet écart de temps minimal est, en moyenne, de une fois sur la durée correspondant au temps moyen prédéterminé entre défaillances ou MTBF.

Puis, on passe d'un écart temporel relatif à l'instant d'échantillonnage critique à un écart de potentiels relatif au potentiel d'équilibre métastable, en utilisant la pente du signal interne de la bascule qui force le potentiel sur le point d'entrée de la boucle combinatoire de prise de décision quand une nouvelle donnée arrive.

On utilise l'équation :

$$K = \frac{\ell n\left(\dfrac{|V_s - V_{eq}|}{|V_{init} - V_{eq}|}\right)}{T_{res}}$$

dans laquelle :

K est le gain de la boucle combinatoire mesuré précédemment ;

$V_s$ est un potentiel de seuil, au-delà duquel on considère que l'état logique du signal peut être propagé de façon sûre, exprimé par exemple en Volts ;

$V_{init}$ est le potentiel au moment de l'échantillonnage, exprimé par exemple en Volts ;

$V_{eq}$ est le potentiel d'équilibre métastable, exprimé par exemple en Volts ; et

$T_{res}$ est le temps de résolution du circuit de synchronisation, exprimé par exemple en s.

On déduit de cette équation le temps de résolution $T_{res}$ qui ne devrait pas être dépassé statistiquement plus d'une fois sur le temps moyen prédéterminé entre défaillances, et que le circuit de synchronisation doit supporter.

On a donc transformé une contrainte sous forme de temps moyen prédéterminé entre défaillances en un délai de pénalité ou délai additionnel pour la bascule critique considérée.

Aussi, le temps de résolution estimé est ajouté aux contraintes de délai prises en compte par l'outil de synthèse du circuit, lors d'une étape 22. Aussi, dans le cas où le temps de résolution $T_{res}$ est inférieur au temps de cycle du signal de cadencement d'horloge de réception, il est possible de ne plus consacrer le cycle entier derrière la boucle combinatoire de décision, à la métastabilité. S'il reste du temps, il est possible, sans risque, de l'utiliser pour d'autres opérations logiques.

Ainsi, il est possible d'utiliser des outils classiques de synthèse pour effectuer une optimisation du dispositif de synchronisation qui tienne compte de la contrainte de temps moyen statistique prédéterminé entre défaillances du système MTBF relative au problème de métastabilité. De même, le circuit ainsi obtenu peut être validé par des outils classiques d'analyse statistique de timing.

En outre, le circuit obtenu peut être testé en production après fabrication, lors d'une étape 23, avec un modèle de type fautes de transitions ("transition fault model" en langue anglaise). Il est ainsi possible d'effectuer des tests fonctionnels à vitesse réelle du circuit de synchronisation. On indique à l'outil de test le temps de cycle pour une transition à pleine vitesse entre deux ensembles de bascules, sans pouvoir reproduire sur l'outil de test un état métastable dans les bascules critiques, mais en diminuant le temps de la transition d'une quantité égale au temps de résolution.

On peut donc valider que le circuit de synchronisation fabriqué répond aux exigences de tenue à la métastabilité spécifiées par le temps moyen entre défaillances.

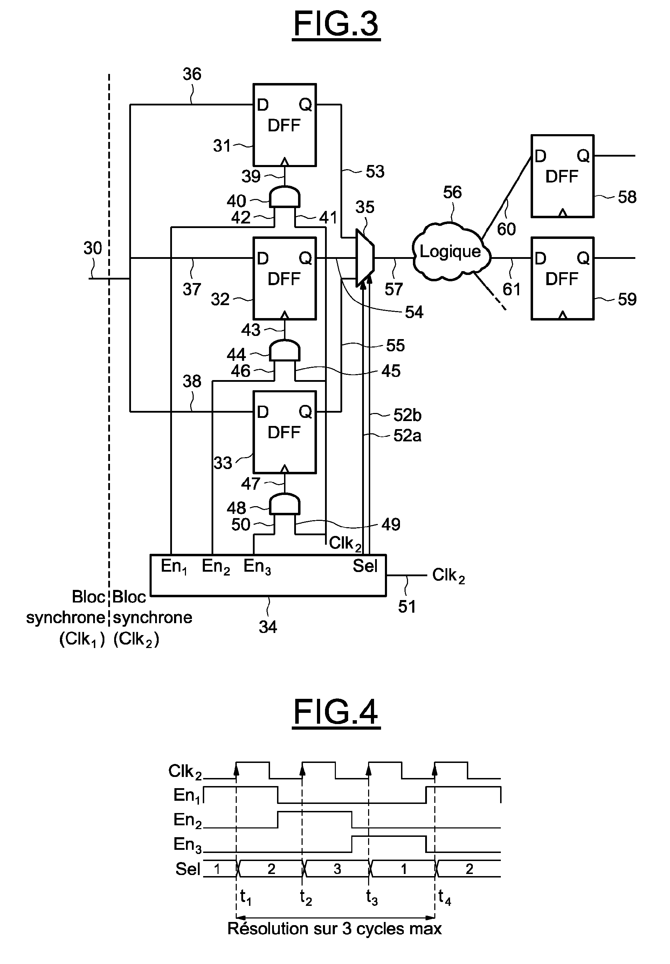

La figure 3 illustre un circuit de synchronisation de données échangées de manière asynchrone entre deux blocs synchrones, élaboré à partir du procédé décrit précédemment.

Un lien 30 permet le transfert de données d'un premier bloc synchrone de signal de cadencement d'horloge $Clk_1$ à un deuxième bloc synchrone, de signal de cadencement d'horloge $Clk_2$.

Trois bascules 31, 32 et 33, capables de générer un signal de décision de réception d'une nouvelle donnée, sont montées en parallèle.

Le circuit comprend, en outre, des moyens de gestion 34 des trois bascules 31, 32 et 33 montées en parallèle, et d'un multiplexeur 35.

La connexion 30 se sépare en trois connexions 36, 37 et 38, respectivement à destination des bascules 31, 32 et 33.

Le signal de cadencement d'horloge de la bascule 31 est fourni par la sortie 39 d'une porte logique ET 40 recevant en entrée le signal de cadencement d'horloge $Clk_2$ du bloc de réception, par une connexion 41, et un signal de validation $En_1$, par une connexion 42.

La bascule 32 reçoit un signal de cadencement d'horloge par une sortie 43 d'une porte logique ET 44 recevant en entrée le signal de cadencement d'horloge $Clk_2$ du bloc de réception par une connexion 45, et un signal de validation $En_2$ par une connexion 46.

La bascule 33 reçoit un signal de cadencement d'horloge par une sortie 47 d'une porte logique ET 48 recevant en entrée le signal de cadencement d'horloge $Clk_2$ du bloc de réception, par une connexion 49, et un signal de validation $En_3$ par une connexion 50.

Les signaux de validation $En_1$, $En_2$ et $En_3$ sont élaborés par les moyens de gestion 34.

Les moyens de gestion 34 reçoivent le signal de cadencement d'horloge $Clk_2$ par une connexion 51, et délivrent des signaux de sélection Sel au multiplexeur 35, par l'intermédiaire de deux connexions 52a et 52b, permettant de sélectionner l'entrée active du multiplexeur 35.

Comme il y a trois entrées sur le multiplexeur 35, la sélection peut être codée sur seulement deux bits d'information, et donc transmise par deux connexions 52a et 52b.

Le multiplexeur 35 reçoit en entrée les sorties respectives 53, 54 et 55 des bascules 31, 32 et 33.

Le multiplexeur 35 est connecté en sortie à un ensemble 56 d'éléments de logique, par une connexion 57.

L'ensemble 56 d'éléments de logique est connecté à deux bascules 58 et 59, respectivement par des connexions 60 et 61.

Ainsi, dans ce circuit de synchronisation, chacune des bascules mises en parallèle échantillonnent à tour de rôle les données en provenance du bloc synchrone d'émission.

Bien entendu, le nombre N de bascules mises en parallèle peut être quelconque, en fonction des spécifications du système, mais l'exemple illustré en contient trois.

On a donc N cycles du signal $Clk_2$ de cadencement d'horloge du bloc de réception pour que soit résolu l'éventuel problème de métastabilité.

Le résultat de la boucle combinatoire de prise de décision n'est exploité qu'après plusieurs cycles du signal de cadencement d'horloge $Clk_2$, comme illustré sur la figure 4.

En effet, tel qu'illustré par les chronogrammes de la figure 4, le signal $Clk_2$ de cadencement d'horloge du bloc de réception comprend des fronts d'échantillonnages successifs correspondant à des instants successifs $t_1$, $t_2$, $t_3$ et $t_4$.

A l'instant $t_1$, le signal de validation $En_1$ active l'échantillonnage de données par la bascule 31, et les signaux de validation $En_2$ et $En_3$ désactivent l'échantillonnage de données par les bascules 32 et 33. Aussi, une donnée arrivant sur la connexion 30 est échantillonnée par la bascule 31 à l'instant $t_1$.

A l'instant $t_2$, le signal de validation $En_2$ active l'échantillonnage de données par la bascule 32, et les signaux de validation $En_1$ et $En_3$ désactivent l'échantillonnage de données par les bascules 31 et 33. Aussi, une donnée arrivant sur la connexion 30 est échantillonnée par la bascule 32 à l'instant $t_2$.

A l'instant $t_3$, le signal de validation $En_3$ active l'échantillonnage de données par la bascule 33, et les signaux de validation $En_1$ et $En_2$ désactivent l'échantillonnage de données par les bascules 31 et 32. Aussi, une donnée arrivant sur la connexion 30 est échantillonnée par la bascule 33 à l'instant $t_3$.

A l'instant $t_4$, comme à l'instant $t_1$, le signal de validation $En_1$ active l'échantillonnage de données par la bascule 31, et les signaux de validation $En_2$ et $En_3$ désactivent l'échantillonnage de données par les bascules 32 et 33. Aussi, une donnée arrivant sur la connexion 30 est échantillonnée par la bascule 31 à l'instant $t_4$.

Les signaux de sélection Sel, au début troisième cycle du signal $Clk_2$ de cadencement d'horloge du bloc de réception, commençant à l'instant $t_3$ et se terminant à l'instant $t_4$, positionne le multiplexeur 35 de sorte que les bascules suivantes 58, 59, reçoivent la sortie de la bascule 31. Ces bascules 58, 59 échantillonnent les données au début du cycle suivant, le quatrième, commençant à l'instant t1.

La sélection Sel du multiplexeur 35 suit celle des bascules d'échantillonnage 31, 32 et 33 par les signaux de validation $En_1$, $En_2$ et $En_3$.

Le système a donc 3 cycles du signal $Clk_2$ de cadencement d'horloge du bloc de réception pour résoudre l'éventuel problème de métastabilité de la boucle combinatoire de la bascule critique qui a échantillonné les données.

De manière à optimiser le circuit de synchronisation, on attend un nombre de cycles égal au nombre de bascules N en parallèle décrémenté de 1, de sorte que, entre le moment où la donnée est échantillonnée par la bascule générant un signal de décision de réception d'une nouvelle donnée et le moment où elle sera à nouveau échantillonnée par une bascule quelconque, il s'écoule un nombre de cycles égal au nombre de bascules mises en parallèle.

Si le temps de résolution $T_{res}$ est compris entre N-1 cycles et N cycles du signal de cadencement d'horloge de réception $Clk_2$, le temps non utilisé pourra être dédié à de la logique, tel que représenté par l'ensemble 56. La figure 4 illustre cela pour le circuit de la figure 3, pour lequel N=3.

Lors de la synthèse, des chemins qui vont des bascules mises en parallèle 31, 32 et 33 aux bascules suivantes 58 et 59 sont déclarés comme des chemins multicycles sur n-cycles ("multicycle path" en langue anglaise).

**Revendications**

1. Procédé de réalisation d'un circuit de synchronisation de données échangées de manière asynchrone entre deux blocs synchrones, ledit circuit comprenant au moins une bascule critique (31, 32, 33) apte à générer un signal de décision de réception d'une nouvelle donnée **caractérisé en ce qu'**il comprend :

   - une étape (20) de mesure du gain de la boucle combinatoire de la bascule critique générant le signal de décision de réception d'une nouvelle donnée ;
   - une étape d'estimation (21) d'un temps de résolution de métastabilité à partir dudit gain et d'un temps moyen statistique prédéterminé entre défaillances ; et
   - une étape d'ajout (22) dudit temps de résolution au paramètre temporel de synthèse de la ou lesdites bascules critiques, ledit paramètre temporel comprenant le temps de propagation du front actif du signal de cadencement d'horloge du bloc de réception, de l'entrée dudit signal à la sortie d'une bascule critique.

2. Procédé selon la revendication 1, dans lequel ladite étape de mesure dudit gain est effectuée en utilisant un simulateur électrique et en calculant la position d'équilibre métastable de la ou lesdites bascules critiques (31, 32, 33), par dichotomie.

3. Procédé selon la revendication 1 ou 2, dans lequel ladite étape d'estimation du temps de résolution de métastabilité comprend :

   - une analyse de la répartition statistique des événements critiquesengendrés par ladite nouvelle donnée reçue, sur un cycle du signal de cadencement d'horloge ($Clk_2$) du bloc de réception, pendant ledit temps moyen statistique prédéterminé entre défaillances (MTBF) ;
   - une détermination d'un délai statistique minimum entre lesdits événements critiques et l'instant critique d'échantillonnage du signal de cadencement d'horloge ($Clk_2$) du bloc de réception, ledit instant critique d'échantillonnage étant l'instant d'arrivée d'une donnée mettant la boucle combinatoire de la bascule critique dans un état de métastabilité permanent;
   - une conversion dudit délai statistique minimum en une différence de potentiels avec le potentiel d'équilibre métastable de la ou lesdites bascules (31, 32, 33) ; et
   - une utilisation de ladite différence de potentiels et dudit gain, pour estimer ledit temps de résolution de métastabilité.

4. Procédé selon l'une des revendications 1 à 3, comprenant, en outre, une étape de test de fabrication (23) dudit circuit de synchronisation de données par un modèle à fautes de transitions en diminuant ledit temps de transition dudit temps de résolution ($T_{res}$).

5. Circuit de synchronisation de données échangées de manière asynchrone entre deux blocs synchrones, élaboré à partir du procédé selon l'une des revendications 1 à 4, **caractérisé en ce qu'**il comprend :

   - un ensemble de N bascules (31, 32, 33) aptes à générer un signal de décision de réception d'une nouvelle donnée, et montées en parallèle ;
   - un multiplexeur (35) recevant en entrée les signaux de sortie des N bascules (31, 32, 33) dudit ensemble ; et
   - des moyens de gestion (34) des N bascules dudit ensemble et dudit multiplexeur (35), aptes à commander un échantillonnage des données reçues, de manière cyclique, par lesdites N bascules (31, 32, 33), et aptes à commander ledit multiplexeur (35) de sorte qu'il transmette les données d'une desdites N bascules (31, 32, 33) avec un décalage de N-1 cycles du signal de cadencement d'horloge ($Clk_2$) du bloc de réception.

6. Circuit selon la revendication 5, dans lequel, le nombre N desdites bascules montées en parallèle (31, 32, 33) correspond au nombre de cycles du signal de cadencement d'horloge ($Clk_2$) du bloc de réception nécessaire et suffisant pour être supérieur ou égal au temps de résolution de métastabilité desdites bascules (31, 32, 33).

**7.** Circuit selon la revendication 5 ou 6, dans lequel le nombre N desdites bascules montées en parallèle est réduit à N=1.

# FIG.1

Cycles de récupération
de la métastabilité

$Clk_1$
Bloc synchrone | Bloc synchrone

# FIG.2

| Mesure gain de boucle combinatoire | ~ 20 |

| Estimation temps de résolution | ~ 21 |

| Ajout du temps de résolution | ~ 22 |

| Test du circuit obtenu | ~ 23 |

# FIG.3

# FIG.4

Résolution sur 3 cycles max